(19) Europäisches Patentamt
European Patent Office
Office européen des brevets

(11) **EP 2 477 393 B1**

(12) **FASCICULE DE BREVET EUROPEEN**

(45) Date de publication et mention
de la délivrance du brevet:
**26.11.2014 Bulletin 2014/48**

(51) Int Cl.:
***H04N 5/374*** *(2011.01)*     ***H04N 5/353*** *(2011.01)*
***H01L 27/146*** *(2006.01)*

(21) Numéro de dépôt: **12151323.8**

(22) Date de dépôt: **16.01.2012**

(54) **Dispositif imageur à grande gamme dynamique**

Bildanzeigevorrichtung mit großem dynamischem Bereich

Imaging device with wide dynamic range

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **17.01.2011 FR 1150364**

(43) Date de publication de la demande:
**18.07.2012 Bulletin 2012/29**

(73) Titulaire: **Commissariat à l'Énergie Atomique
et aux Énergies Alternatives
75015 Paris (FR)**

(72) Inventeurs:
• **Guezzi, Fadoua
38000 Grenoble (FR)**
• **Peizerat, Arnaud
38000 Grenoble (FR)**

(74) Mandataire: **Bonnet, Michel
Cabinet Bonnet
93, Rue Réaumur - Boîte 10
75002 Paris (FR)**

(56) Documents cités:
**US-A1- 2002 196 170     US-A1- 2005 157 202
US-A1- 2008 083 939**

## Description

La présente invention concerne un dispositif imageur, ou capteur d'images, à grande gamme dynamique. Elle s'applique notamment aux imageurs CMOS réalisés en technologie silicium comportant des pixels de petite taille et aptes à réaliser une détection optique dans le domaine visible.

Un dispositif imageur à grande gamme dynamique est un imageur conçu pour être sensible à une dynamique de luminance étendue dans une même image acquise par ses capteurs photosensibles. L'image acquise n'est ainsi ni surexposée dans ses zones de forte intensité lumineuse, ni sous-exposée dans ses zones de faible intensité lumineuse : elle comporte une information détaillée à la fois dans ces deux types de zones extrêmes de l'image.

Un dispositif imageur, conçu sous forme de circuit intégré, comporte généralement :

- un premier substrat destiné à être exposé à la lumière sur lequel est disposée une pluralité de pixels, par exemple disposés en matrice, chaque pixel comportant un photodétecteur, et
- une pluralité de circuits de lecture associés à la pluralité de photodétecteurs, chaque circuit de lecture comportant un dispositif de charge et de décharge d'au moins un photodétecteur associé à ce circuit de lecture, chaque dispositif de charge et de décharge étant commandé par un signal d'activation de la charge et de la décharge.

Ces circuits de lecture font plus généralement partie d'un circuit électronique de contrôle qui se charge d'évacuer de manière série l'information électrique contenue dans chaque pixel jusqu'à la sortie de la matrice.

Le photodétecteur d'un pixel est chargé de convertir l'énergie de photons incidents en paires électrons-trous. Il est ainsi conçu pour accumuler une charge électrique entre ses bornes en fonction d'une intensité lumineuse reçue par le pixel pendant un temps d'exposition appelé également en électronique temps d'intégration, puis pour transmettre au reste du circuit cette charge accumulée sous forme d'une tension révélatrice de cette intensité lumineuse. Le temps d'intégration est compris entre un instant de charge où le dispositif de charge et de décharge commande le début d'une accumulation de charge électrique aux bornes du photodétecteur et un instant de décharge où il commande la fin de cette accumulation de charge par réinitialisation de la tension aux bornes du photodétecteur à une tension de référence. En technologie CMOS, le dispositif de charge et de décharge est ainsi par exemple un transistor à effet de champ commandé par un signal d'activation fourni à sa grille.

Pour obtenir un dispositif imageur à grande gamme dynamique, il est possible de jouer sur deux facteurs : l'ajustement de la capacité d'intégration pour un temps d'intégration donné ou l'adaptation du temps d'intégration à capacité d'intégration donnée.

La présentation de El Gamal, intitulée « High dynamic range image sensors » et faite à la conférence IEEE 2002 « International Solid-State Circuits Conference », propose un ajustement de la capacité d'intégration. Pendant un même cycle d'intégration à temps d'intégration prédéterminé, le signal d'activation du dispositif de charge et de décharge est susceptible de prendre une ou plusieurs valeurs non binaires entre 0 et 1 pour ajuster la capacité d'intégration, ce qui revient à ajuster la pente de la courbe de stockage de charge aux bornes du photodétecteur en fonction du courant photonique pour éviter une saturation de charge avant la fin du cycle. Bien que cette solution ne modifie pas l'architecture du substrat formant support des pixels et des circuits de lecture, deux inconvénients majeurs sont, d'une part, de fournir une réponse qui n'est pas linéaire mais linéaire par morceaux et, d'autre part, d'avoir une perte de rapport signal sur bruit (ou SNR, de l'Anglais « Signal Noise Ratio »). Ceci cause des problèmes aux niveaux des zones de non linéarité qui ne sont pas définies à l'avance.

Il semble alors préférable de jouer sur une adaptation du temps d'intégration. Une telle solution est par exemple décrite dans l'article de Yang et al, intitulé « High dynamic range CMOS image sensor with conditional reset », publié lors de la conférence IEEE 2002 « Custom Integrated Circuits Conference ». Elle consiste à exécuter à plusieurs reprises dans un même cycle d'intégration une lecture de la charge accumulée aux bornes du photodétecteur d'un pixel par une mesure de tension et à exécuter, le cas échéant, des réinitialisations conditionnées à ces lectures : lorsque la tension mesurée atteint une tension de seuil prédéterminée, elle est réinitialisée à la tension de référence précitée et l'instant de réinitialisation est conservé en mémoire avec la valeur mesurée. En choisissant astucieusement les instants successifs de lectures et de réinitialisations éventuelles, notamment espacés selon des durées croissant exponentiellement en puissances de 2, il est possible de déduire simplement de ces lectures successives une valeur pour chaque pixel déterminable dans une grande dynamique de valeurs.

Mais cette solution de réinitialisations conditionnelles est limitée en rapidité de réponse car plusieurs lectures successives sont nécessaires, ce qui est aussi très consommateur d'énergie. En outre, l'architecture de chaque pixel est nécessairement modifiée par l'introduction de composants électroniques spécifiques chargés de la génération du signal de réinitialisation conditionnelle. En particulier, pour un pixel d'architecture 3T (i.e. pixel en technologie CMOS à trois transistors), il est nécessaire d'ajouter deux transistors pour générer ce signal. Ceci diminue la performance du pixel en termes de surface photosensible.

Une amélioration de cette solution est présentée dans l'article de Acosta-Serafini et al, intitulé « A 1/3" VGA linear wide dynamic range CMOS image sensor implementing a predictive multiple sampling algorithm with overlapping integration intervals », publié dans IEEE Journal of Solid-State Circuits, vol. 39, n° 9, septembre 2004. Selon cette amélioration, les lectures successives sont elles aussi soumises à condition. Plus précisément, elles sont conditionnées à l'intensité d'éclairement du pixel considéré. Pour un pixel faiblement éclairé à un premier instant de lecture, le cycle d'intégration continue jusqu'à son terme sans nouvelle lecture. Au dessus d'un premier seuil, une deuxième lecture est réalisée et le test est reproduit avec un deuxième seuil, et ainsi de suite.

Cette solution de lectures et réinitialisations conditionnelles accélère l'acquisition de l'image mais reste relativement consommatrice d'énergie. En outre, l'architecture de chaque pixel reste nécessairement modifiée par l'introduction de composants électroniques spécifiques chargés de la génération du signal de lectures et réinitialisations conditionnelles. En particulier, pour un pixel d'architecture 4T (i.e. pixel en technologie CMOS à quatre transistors), l'article précise qu'il est nécessaire d'ajouter un transistor pour générer ce signal. Ceci diminue, comme dans l'exemple précédent, la performance du pixel en termes de surface photosensible.

Il peut ainsi être souhaité de prévoir un dispositif imageur à grande gamme dynamique qui permette de s'affranchir d'au moins une partie des problèmes et contraintes précités. Le document US-A-2008/0083939 divulgue un capteur d'image avec deux substrats superposés. L'invention a donc pour objet un dispositif imageur à grande gamme dynamique comportant :

- un premier substrat destiné à être exposé à la lumière sur lequel est disposée une pluralité de pixels, chaque pixel comportant un photodétecteur, et
- une pluralité de circuits de lecture associés à la pluralité de photodétecteurs, chaque circuit de lecture comportant un dispositif de charge et de décharge d'au moins un photodétecteur associé à ce circuit de lecture, chaque dispositif de charge et de décharge étant commandé par un signal d'activation de la charge et de la décharge,

imposant un temps d'intégration du photodétecteur de chaque pixel associé au circuit de lecture,

le dispositif imageur comportant en outre un second substrat, distinct du premier substrat, sur lequel est disposé un circuit électronique de commande desdits dispositifs de charge et de décharge, conçu pour la génération d'une pluralité de signaux d'activation de charge et de décharge destinés à être transmis auxdits dispositifs de charge et de décharge par l'intermédiaire de liaisons électriques entre le premier substrat et le second substrat, chaque pixel ou groupe de pixels étant associé à un signal d'activation imposant un temps d'intégration propre et approprié à ce pixel ou groupe de pixels.

Ainsi, en déportant la génération des signaux d'activation destinés à être transmis aux dispositifs de charge et de décharge sur un autre substrat que celui sur lequel sont disposés les pixels, il devient possible de paramétrer plus finement l'adaptation du temps d'intégration à l'aide d'un circuit de commande dédié sans pour autant modifier voire alourdir la structure du premier substrat.

De façon optionnelle, les premier et second substrats sont superposés et la pluralité de circuits de lecture est disposée sur le premier substrat, ladite au moins une liaison électrique comportant au moins l'un des éléments de l'ensemble constitué d'un via traversant réalisé à travers le premier et/ou le second substrat, d'une bille électriquement conductrice reliant électriquement un contact électrique du premier substrat à un contact électrique du second substrat, d'un contact électrique du premier substrat collé par adhésion moléculaire à un contact électrique du second substrat et de couplages capacitifs entre des contacts électriques respectifs des premier et second substrats.

De façon optionnelle également, le circuit électronique de commande comporte :

- une pluralité d'éléments de génération de signal d'activation, et
- un bloc d'évaluation de temps d'intégration destinés à être appliqués à la pluralité de pixels, conçu pour calculer et transmettre un paramètre de temps d'intégration définissant un temps d'intégration propre et approprié à chaque élément de génération de signal d'activation.

De façon optionnelle également, un dispositif imageur selon l'invention comporte un bloc de référence conçu pour la fourniture d'une base de temps d'intégration de référence, et chaque élément de génération de signal d'activation comporte un circuit de génération d'un signal d'activation à partir de la base de temps d'intégration fournie par le bloc de référence et du paramètre de temps d'intégration fourni par le bloc d'évaluation.

De façon optionnelle également, chaque paramètre de temps d'intégration, noté EXP, reçu par chaque élément de génération de signal d'activation définit un temps d'intégration $T_{int}$ appliqué par le signal d'activation généré par cet élément, selon la relation suivante :

$$T_{\text{int}} = T_{ligne} \cdot 2^{N-EXP}, \quad où \quad EXP \in \{0,\ldots,N\},$$

$T_{ligne}$ étant un temps minimal d'intégration et N une valeur entière maximale prise par le paramètre de temps d'intégration.

Ce format de valeurs possibles pour les temps d'intégration appliqués aux pixels permet un codage sous forme de mantisse et d'exposant de la valeur à grande gamme dynamique de chaque pixel, ce qui garantit non seulement la linéarité de la réponse du pixel mais aussi une meilleure compression des données puisqu'il constitue lui-même une première étape de compression.

De façon optionnelle également, le bloc d'évaluation de temps d'intégration est conçu pour, sur la base d'une valeur courante de chaque paramètre de temps d'intégration et d'une valeur courante de luminance de chaque pixel mesurée par chaque circuit de lecture, calculer une nouvelle valeur de chaque paramètre de temps d'intégration.

De façon optionnelle également, le circuit électronique de commande comporte un élément de génération de signal d'activation par pixel.

De façon optionnelle également, les pixels étant répartis en groupes de pixels, notamment en blocs ou macro-blocs de pixels, le circuit électronique de commande comporte un élément de génération de signal d'activation par groupe de pixels.

De façon optionnelle également, les pixels sont disposés en matrice sur le premier substrat et le circuit électronique de commande comporte une pluralité d'éléments de génération de signal d'activation disposés en matrice sur le second substrat, chaque élément de génération de signal d'activation étant relié à un pixel ou groupe de pixels par l'intermédiaire d'une liaison électrique entre les premier et second substrat.

De façon optionnelle également :

- chaque circuit de lecture comporte trois transistors, un transistor de réinitialisation, un transistor suiveur et un transistor de sélection de ligne, et
- le dispositif de charge et de décharge comporte le transistor de réinitialisation.

De façon optionnelle également :

- chaque circuit de lecture comporte quatre transistors, un transistor de réinitialisation, un transistor de transfert, un transistor suiveur et un transistor de sélection de ligne, et
- le dispositif de charge et de décharge comporte le transistor de transfert.

L'invention sera mieux comprise à l'aide de la description qui va suivre, donnée uniquement à titre d'exemple et faite en se référant aux dessins annexés dans lesquels :

- la figure 1 représente schématiquement la structure générale d'un dispositif imageur à grande gamme dynamique, selon un mode de réalisation de l'invention,
- les figures 2 à 4 représentent schématiquement la structure générale d'un pixel du dispositif imageur de la figure 1, conformément à trois modes de réalisation compatibles avec l'invention,
- la figure 5 représente schématiquement la structure générale d'un élément de génération de signal d'activation du dispositif imageur de la figure 1, conformément à un mode de réalisation de l'invention,
- la figure 6 illustre à l'aide de diagrammes la génération d'un signal d'activation par l'élément de la figure 5,
- la figure 7 illustre les étapes d'un procédé mis en oeuvre par un bloc d'évaluation de temps d'intégration du dispositif imageur de la figure 1, conformément à un mode de réalisation de l'invention, et
- la figure 8 représente schématiquement la structure générale d'un mode de réalisation du bloc d'évaluation mettant en oeuvre le procédé de la figure 7.

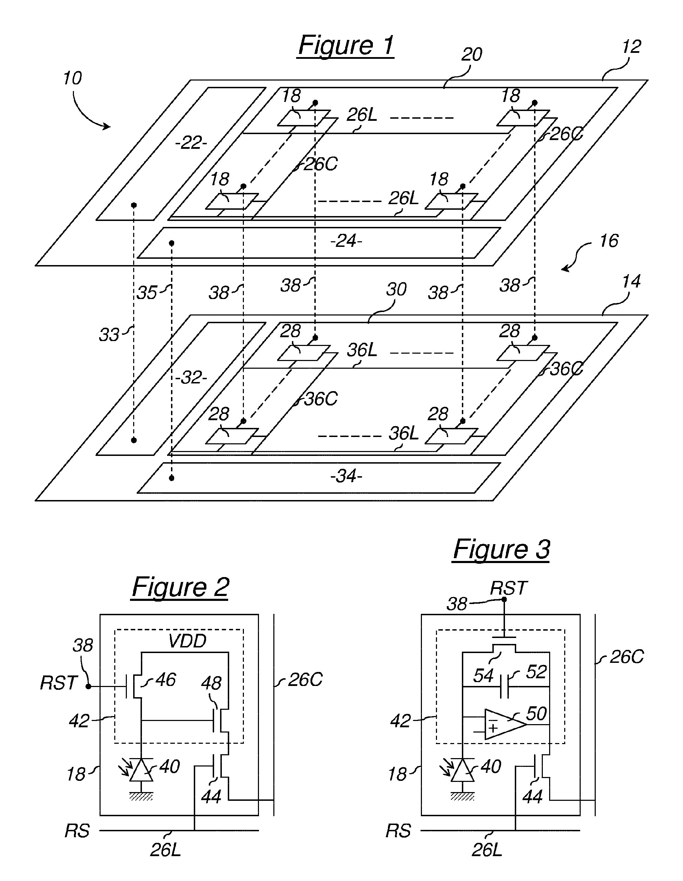

Le dispositif imageur 10 représenté sur la figure 1 comporte un premier substrat 12 destiné à être exposé à la lumière. Il est par exemple conçu en technologie CMOS et le substrat 12 est en matériau semi-conducteur tel que du silicium. Il comporte également un second substrat 14, également en silicium, superposé au premier substrat 12 et relié à celui-ci électriquement par l'intermédiaire d'au moins une liaison électrique 16 entre au moins un élément du premier substrat 12 et un élément du second substrat 14. On obtient ainsi un dispositif imageur réalisé en technologie 3D, c'est-à-dire se présentant sous la forme d'un empilement de plusieurs couches de circuits intégrés, autrement qualifié de puce 3D, chaque couche de l'empilement étant elle-même qualifiée de puce 2D.

D'une façon générale, l'intérêt d'une architecture 3D réside, notamment :

- pour une puce de grande surface, dans la réduction de la longueur des interconnexions entre composants permettant une communication plus rapide, et
- pour un dispositif nécessitant plusieurs puces, dans l'augmentation du nombre d'interconnexions entre les puces permettant une communication non plus série mais massivement parallèle.

Dans l'exemple illustré sur la figure 1, indiqué à titre non limitatif dans le cas d'une capture d'images ligne par ligne selon la technique de « rolling shutter », cette architecture 3D comporte un intérêt supplémentaire compte tenu de la répartition choisie des composants du dispositif imageur 10 entre les deux substrats 12 et 14. En effet, les composants classiques de base de capture d'images d'un dispositif imageur 2D tels que les pixels et leurs circuits de commande et de lecture associés sont intégrés sur le premier substrat 12, tandis que des composants spécifiques de commande adaptative des temps d'intégration de chaque pixel ou groupe de pixels sont intégrés sur le second substrat 14 pour permettre une capture d'images à grande gamme dynamique. Ainsi, il devient possible de concevoir un dispositif imageur 3D à grande gamme dynamique en paramétrant plus finement l'adaptation du temps d'intégration de chaque pixel à l'aide de composants intégrés sur le second substrat sans pour autant modifier voire alourdir la structure 2D d'imageur classique du premier substrat.

Pour ce faire, le premier substrat 12 intègre plus précisément une pluralité de pixels 18 répartis régulièrement selon deux directions principales perpendiculaires, formant ainsi une matrice 20 de détection de luminance, chaque pixel comportant un photodétecteur et un circuit de lecture associé comprenant notamment un dispositif de charge et de décharge de ce photodétecteur.

Dans l'exemple particulier de la figure 1, il intègre en outre les composants suivants :

- un bloc 22 de sélection de ligne, disposé en vis-à-vis des lignes de la matrice 20, conçu pour transmettre à la matrice 20, via des bus 26L de transmission de données interconnectant chacun une ligne de pixels, des signaux RS de déclenchement d'une lecture des valeurs des pixels 18 ligne par ligne, selon la technique de « rolling shutter »,
- un bloc 24 de conversion analogique/numérique, situé en pied de colonnes de la matrice 20 pour recevoir, via des bus 26C de transmission de données interconnectant chacun une colonne de pixels, des valeurs analogiques des pixels lues ligne par ligne, et pour convertir ces valeurs analogiques en valeurs numériques selon un format prédéterminé.

Le second substrat 14 intègre un circuit électronique de commande des dispositifs de charge et de décharge de photodétecteurs répartis sur le premier substrat 12, ce circuit électronique de commande comportant les composants suivants :

- une pluralité d'éléments 28 de génération de signaux d'activation répartis régulièrement selon deux directions principales perpendiculaires, formant ainsi une matrice 30 de génération de signaux d'activation des dispositifs de charge et de décharge du premier substrat, chaque élément 28 comportant une mémoire de stockage d'un paramètre de temps d'intégration et un circuit de génération d'un signal d'activation à partir d'une base de temps d'intégration de référence et du paramètre de temps d'intégration,
- un bloc de référence 32, disposé en vis-à-vis des lignes de la matrice 30 et relié au bloc 22 de sélection de ligne par une liaison électrique 33, conçu pour fournir à la matrice 30, via des bus 36L de transmission de données interconnectant chacun une ligne d'éléments 28, des signaux d'indication de la base de temps d'intégration de référence ligne par ligne,
- un bloc 34, relié au bloc 24 de conversion analogique/numérique par une liaison électrique 35 pour recevoir la valeur des pixels et situé en pied de colonnes de la matrice 30, servant à l'évaluation des temps d'intégration destinés à être appliqués à la matrice 20 de pixels 18, et transmettant aux éléments 28 de la matrice 30, via des bus 36C de transmission de données interconnectant chacun une colonne d'éléments 28, les nouveaux paramètres de temps d'intégration évalués.

Selon différentes variantes de réalisation possibles, les blocs 22 et 24 de sélection de ligne et de conversion analogique/numérique ne sont pas nécessairement disposés sur le premier substrat 12 destiné à être exposé à la lumière. Ils peuvent être disposés, l'un ou l'autre, sur le second substrat 14 ou même sur au moins un autre substrat, par exemple un substrat intermédiaire intercalé entre le premier et le second substrat. En particulier, lorsqu'au moins un substrat intermédiaire est intercalé entre le premier et le second substrat pour recevoir les blocs 22 et 24, et éventuellement les circuits de lecture des pixels, l'ensemble constitué du premier substrat et de ce ou de ces substrat(s) intermédiaire(s) forme en tant que tel une puce 3D dont seul le premier substrat est destiné à être exposé à la lumière parce que c'est celui qui comporte la surface photosensible constituée par les photodétecteurs. On notera cependant que, d'une façon générale, on préfère prévoir les photodétecteurs et leurs circuits de lecture associés sur un même substrat pour des questions de contraintes sur les interconnexions électriques entre substrats.

Dans l'exemple particulier illustré sur la figure 1, il est prévu autant d'éléments 28 de génération de signaux d'activation sur le second substrat 14 que de pixels 18 sur le premier substrat 12. La liaison électrique 16 comporte alors une pluralité de connexions électriques verticales 38, chaque connexion électrique verticale 38 reliant un élément 28 du second substrat 14 à un pixel 18 disposé en vis-à-vis sur le premier substrat 12. Les connexions électriques verticales 38 sont par exemple constituées de vias traversants réalisés à travers le premier et/ou le second substrats, de billes électriquement conductrices reliant électriquement chacune un contact électrique d'un élément 28 à un contact électrique d'un pixel 18, de contacts électriques des éléments 28 collés par adhésion moléculaire à des contacts électriques des pixels 18 ou de couplages capacitifs entre les éléments 28 et les pixels 18. Grâce à ces connexions électriques 38, chaque élément 28 transmet le signal d'activation qu'il a généré au dispositif de charge et de décharge du pixel 18 correspondant.

Dans une variante de réalisation, il peut être prévu moins d'éléments 28 de génération de signaux d'activation sur le second substrat 14 que de pixels sur le premier substrat 12, chaque élément 28 adressant son signal d'activation à un groupe de pixels, notamment un bloc ou macro-bloc de 2x2, 4x4, 8x8, 16x16 ou 32x32 pixels. Par ailleurs, et en combinaison avec ce qui précède, conformément à certaines architectures d'imageurs 2D, il peut être prévu que les pixels 18 ne comportent pas chacun leur propre circuit de lecture, ces derniers étant communs à plusieurs pixels. Dans ce cas, chaque élément 28 de génération de signal d'activation est associé à un ou plusieurs dispositifs de charge et de décharge d'un ou plusieurs circuits de lectures eux-mêmes associés à plusieurs pixels 18.

Le premier substrat 12 peut comporter un très grand nombre de pixels, plusieurs millions voire plusieurs dizaines de millions, de forme carrée et de dimensions voisines de 2 à 5 $\mu$m.

Selon un premier mode de réalisation possible des pixels compatible avec une mise en oeuvre de l'invention, l'un quelconque des pixels 18 est représenté sur la figure 2 conformément à une architecture bien connue, dite « 3T », c'est-à-dire présentant une électronique analogique formée par trois transistors MOS.

Ce pixel 3T comporte un photodétecteur, par exemple une photodiode 40, destiné à convertir l'énergie de photons incidents reçus en paires électrons-trous. Dans une variante, le photodétecteur 40 pourrait être un phototransistor.

Il comporte également un circuit de lecture 42 des charges générées par la photodiode 40. Ce circuit de lecture 42 comporte notamment un circuit assurant la charge et la décharge de la photodiode 40 ainsi que la conversion des charges générées par la photodiode 40 et stockées dans sa capacité de jonction pendant un temps d'intégration du pixel 18.

Enfin, le pixel 18 comporte également des moyens 44 de sélection de ligne permettant, sur réception du signal RS correspondant à la ligne sur laquelle se trouve le pixel 18 et en fonction de la valeur de ce signal RS, de lire les informations de luminance stockées par le pixel 18 pendant son temps d'intégration. Les moyens 44 de sélection de ligne sont plus précisément constitués d'un transistor MOS dont la grille reçoit le signal RS.

Le circuit de lecture 42 comporte un premier transistor MOS 46 dont la source est reliée à la photodiode 40 et le drain à un potentiel VDD. Il comporte en outre un second transistor MOS 48 dont le drain est également relié au potentiel VDD et la source au drain du transistor 44 de sélection de ligne. Par ailleurs, la grille du second transistor 48 est reliée à la source du premier transistor 46.

La grille du premier transistor 46 est reliée à l'une des connexions verticales 38 pour recevoir le signal d'activation de charge et de décharge correspondant. Le premier transistor 46 constitue ainsi le dispositif de charge et de décharge de la photodiode 40 pour ce pixel 3T et permet de réinitialiser le pixel 18 lorsque ce premier transistor 46 est mis à l'état passant, la tension aux bornes de la capacité de jonction de la photodiode 40 étant alors mise à VDD. Dans ce mode de réalisation, le signal d'activation de charge et de décharge transmis au premier transistor 46 est noté RST.

Le second transistor 48 forme un suiveur de tension réalisant la conversion des charges stockées dans la capacité de jonction de la photodiode 40 en une tension.

Enfin, le transistor 44 de sélection de ligne permet de délivrer, lorsque l'on adresse la ligne sur laquelle se trouve le pixel 18, c'est-à-dire en mettant ce transistor 44 à l'état passant à l'aide du signal RS, la tension fournie par le second transistor 48 sur le bus 26 auquel est raccordé le pixel 18.

Selon un deuxième mode de réalisation possible des pixels compatible avec une mise en oeuvre de l'invention, l'un quelconque des pixels 18 est représenté sur la figure 3 conformément à une architecture bien connue, dite « CTIA ».

Ce pixel CTIA comporte, comme le précédent, une photodiode 40, un circuit de lecture 42 et un transistor 44 de sélection de ligne.

Mais le circuit de lecture 42, différent du précédent, comporte un amplificateur 50 dont l'entrée négative est reliée à la photodiode 40 et l'entrée positive à une source de tension de polarisation. La sortie de l'amplificateur 50 est reliée à son entrée négative par l'intermédiaire d'une capacité 52 et d'un transistor MOS 54, ces deux éléments étant reliés en parallèle l'un à l'autre. La sortie de l'amplificateur 50 est également reliée à la source (ou au drain, car la source et le drain sont interchangeables) du transistor 44 de sélection de ligne.

La grille du transistor 54 est reliée à l'une des connexions verticales 38 pour recevoir le signal d'activation de charge et de décharge correspondant. Le transistor 54 constitue ainsi le dispositif de charge et de décharge de la photodiode 40 pour ce pixel CTIA. Dans ce mode de réalisation également, le signal d'activation de charge et de décharge transmis au transistor 54 est noté RST.

Dans ce deuxième mode de réalisation du pixel 18, la conversion de charges en tension est réalisée par l'ensemble constitué de l'amplificateur 50 et de la capacité 52.

Enfin, le transistor 44 de sélection de ligne permet de délivrer, lorsque l'on adresse la ligne sur laquelle se trouve le pixel 18, c'est-à-dire en mettant ce transistor 44 à l'état passant à l'aide du signal RS, la tension fournie en sortie de l'amplificateur 50 sur le bus 26 auquel est raccordé le pixel 18.

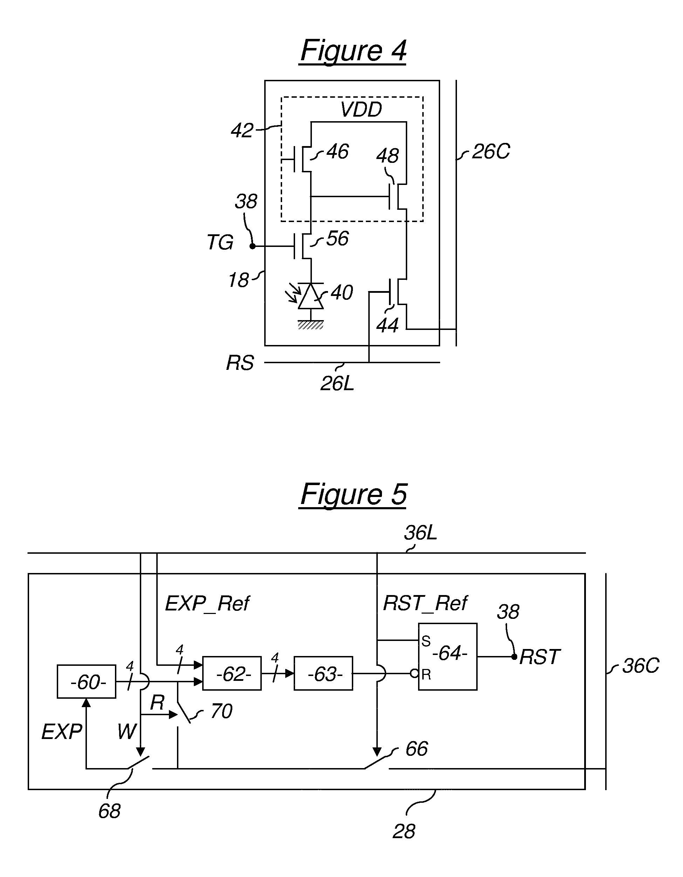

Selon un troisième mode de réalisation possible des pixels compatible avec une mise en oeuvre de l'invention, l'un quelconque des pixels 18 est représenté sur la figure 4 conformément à une architecture bien connue, dite « 4T », c'est-à-dire présentant une électronique analogique formée par quatre transistors MOS.

Ce pixel 4T comporte, comme les précédents, une photodiode 40, un circuit de lecture 42 et un transistor 44 de sélection de ligne.

Le circuit de lecture 42 de ce pixel 4T est identique à celui du pixel 3T de la figure 2, à l'exception du fait qu'un transistor de transfert 56 s'interpose entre la source du premier transistor 46 et la photodiode 40.

Ce transistor de transfert 56 assure une isolation entre le circuit de lecture 42 et la photodiode 40, et permet de réaliser directement l'intégration des charges générées par la photodiode 40 lors de la décharge de sa capacité de jonction sans avoir à réinitialiser la photodiode 40 pour obtenir la mesure réalisée par le pixel 18. Plus spécifiquement, il permet, dans son but premier, de réaliser un double échantillonnage corrélé pour éliminer le bruit de réinitialisation et le bruit spatial fixe. Dans le cas d'un imageur à grande gamme dynamique, on peut aussi l'utiliser pour contrôler le temps d'intégration.

La grille du transistor de transfert 56 est reliée à l'une des connexions verticales 38 pour recevoir le signal d'activation de charge et de décharge correspondant. Le transistor de transfert 56 constitue ainsi le dispositif de charge et de décharge de la photodiode 40 pour ce pixel 4T. Dans ce mode de réalisation, le signal d'activation de charge et de décharge transmis au transistor de transfert 56 est noté TG.

Enfin, comme dans les modes de réalisation précédent, le transistor 44 de sélection de ligne permet de délivrer, lorsque l'on adresse la ligne sur laquelle se trouve le pixel 18, c'est-à-dire en mettant ce transistor 44 à l'état passant à l'aide du signal RS, la tension fournie par le second transistor 48 sur le bus 26 auquel est raccordé le pixel 18.

La figure 5 représente schématiquement la structure générale possible d'un élément 28 de génération de signal d'activation du dispositif imageur 10, conformément à un mode de réalisation de l'invention dans lequel le dispositif imageur 10 présente autant d'éléments 28 que de pixels 18, dans lequel les pixels 18 sont conformes au pixel 3T de la figure 2 et dans lequel le mode de lecture de la matrice 20 est le « rolling shutter ». Mais d'une façon plus générale, et comme cela a été montré en référence aux figures 3 et 4, l'invention s'applique à tout type de pixels, notamment aux pixels CTIA et 4T, en adaptant la transmission des signaux d'activation de charge et de décharge au cas par cas. De même, l'invention s'applique quel que soit le mode de lecture, « rolling shutter » ou « global shutter ». De même l'invention s'applique à des imageurs dont chaque élément 28 de génération de signal d'activation adresse son signal d'activation de charge et de décharge à plusieurs pixels 18.

L'élément 28 de génération de signal d'activation de la figure 5 comporte une mémoire 60 de stockage d'un paramètre EXP de temps d'intégration et un circuit 62, 63, 64 de génération d'un signal d'activation RST destiné à être transmis au pixel 18 correspondant via l'une des connexions verticales 38.

Selon un mode de réalisation possible de l'invention, le temps d'intégration $T_{int}$ d'un pixel peut prendre plusieurs valeurs identifiées par le paramètre EXP, entre une valeur minimale $T_{ligne}$, qui correspond au temps minimal nécessaire pour l'intégration et la lecture des pixels d'une même ligne, et une valeur maximale $T_{image}$, qui vaut $L.T_{ligne}$, où L est inférieur ou égal au nombre de lignes dans la matrice 20 de pixels 18. Pour faciliter les calculs et donc l'implémentation, L est de préférence une puissance de 2 et peut alors s'écrire sous la forme $L = 2^N$. Dans ce cas, il est également pratique que les valeurs de temps d'intégration possibles soient les suivantes :

$$T_{int} = T_{ligne} \cdot 2^{N-EXP} = \frac{T_{image}}{2^{EXP}}, \quad où \quad EXP \in \{0,\ldots,N\}.$$

La valeur du pixel 18 soumis au temps d'intégration $T_{int}$ peut donc s'exprimer numériquement sous la forme $M.2^{EXP}$, où M est la valeur numérisée retournée par le bloc 24 de conversion analogique/numérique à partir de la tension qui lui a été fournie lors de la lecture du pixel. M est appelée la mantisse de la valeur du pixel et EXP son exposant. Si M est codée par exemple sur 10 bits, la dynamique du pixel devient 10+N grâce aux N+1 temps d'intégration possibles alors que le paramètre EXP peut être codé sur moins de N bits, en l'occurrence sur $E(\log_2 N)+1$ bits, où E() désigne la fonction « partie entière ».

Par exemple, pour N=10, on obtient une valeur de pixel qui peut être codée sur 14 bits avec une dynamique de 20 bits, ce qui constitue une première compression de données. Dans ce cas, la mémoire 60 peut être constituée d'une mémoire SRAM de 4 bits pour le stockage du paramètre de temps d'intégration EXP dont la valeur est comprise entre 0 et 10.

Le circuit de génération du signal d'activation RST comporte un comparateur bit à bit « ou exclusif » 62 recevant, sur un bus de quatre bits, la valeur de EXP stockée en mémoire 60 et, sur un bus de quatre bits également, un signal EXP_Ref de fourniture des différentes valeurs possibles de EXP. La sortie du comparateur bit à bit « ou exclusif » 62 est transmise par un bus de quatre bits à une porte logique « ou » 63 dont la sortie binaire reste à « 1 » tant que EXP est différent de la valeur de référence fournie par le signal EXP_Ref et passe à « 0 » dès que cette valeur de référence prend celle de EXP.

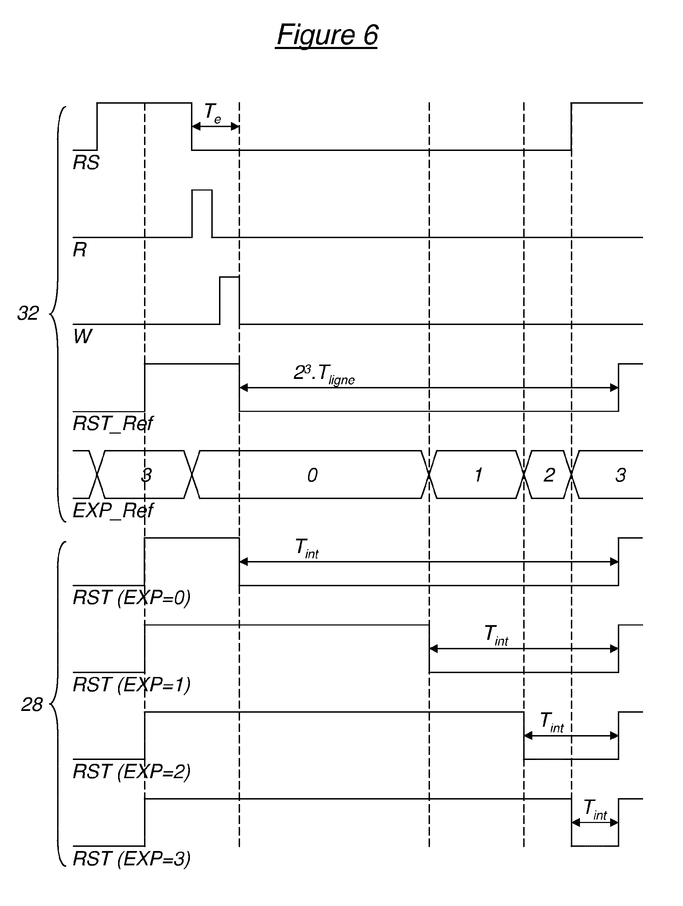

La sortie de la porte logique « ou » 63 est fournie en entrée R inversée d'une bascule RS classique 64. L'autre entrée S de la bascule RS 64 reçoit un signal binaire RST_Ref d'activation de référence, permettant, comme cela sera détaillé en référence à la figure 6, de fournir en sortie de la bascule RS, le signal d'activation binaire RST adapté à la valeur de EXP. La sortie de la bascule 64 est donc connectée à la connexion verticale 38 qui relie l'élément 28 au pixel 18 correspondant.

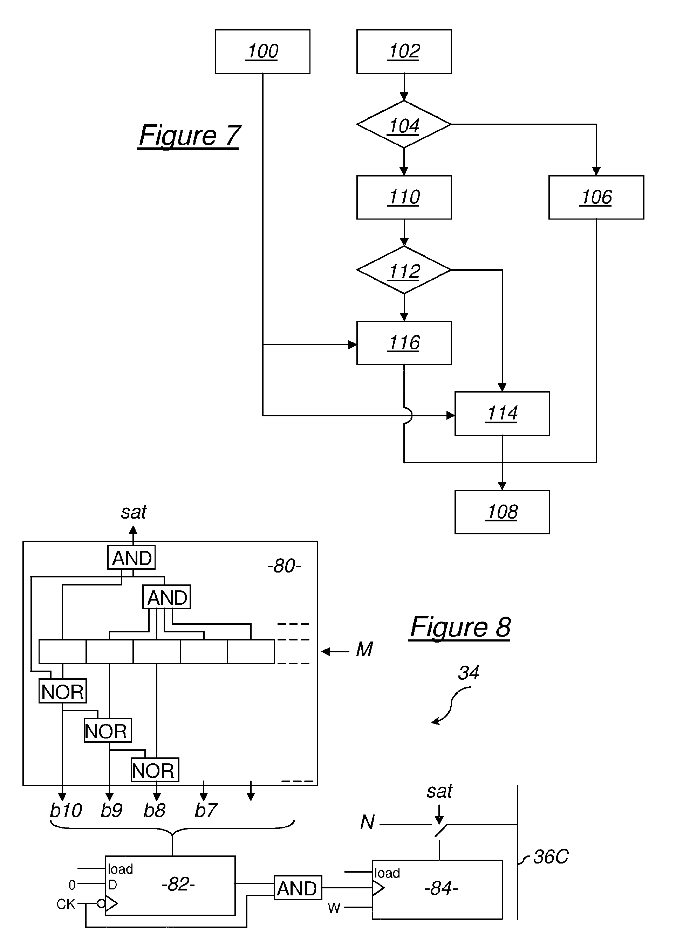

Comme cela sera détaillé en référence à la figure 7, la valeur de EXP est évaluée et mise à jour par le bloc d'évaluation 34, de sorte que la mémoire 60 de l'élément 28 de génération de signal d'activation est accessible en lecture et en écriture par le bloc d'évaluation 34 via le bus 36C correspondant. Plus précisément, à l'intérieur de l'élément 28, l'entrée de la mémoire 60 est reliée au bus 36C via une liaison comprenant un premier interrupteur 66 commandé par le signal RST_Ref et un second interrupteur 68 commandé par un signal binaire W indiquant précisément la bonne fenêtre temporelle d'écriture dans la mémoire 60. A l'intérieur de l'élément 28 également, la sortie de la mémoire 60 est reliée au bus 36C via une liaison comprenant le premier interrupteur 66 et un second interrupteur 70 commandé par un signal binaire R indiquant précisément la bonne fenêtre temporelle de lecture dans la mémoire 60.

Les signaux EXP_Ref, RST_Ref, W et R sont fournis à l'élément 28 par le bloc de référence 32 via le bus 36L correspondant. Plus précisément, EXP_Ref et RST_Ref constituent des signaux d'indication de la base de temps d'intégration de référence à partir de laquelle l'élément 28 est capable, à l'aide également du paramètre de temps d'intégration EXP, de générer le signal d'activation RST adéquat et de le transmettre au pixel 18 auquel il est associé. Le signal RS généré par le bloc de sélection de ligne 22 peut également servir dans le bloc de référence 32 pour que les signaux EXP_Ref, RST_Ref, W et R s'accordent sur lui.

Sur la base des signaux RS, EXP_Ref, RST_Ref, W et R générés par le bloc de référence 32, le fonctionnement de l'un quelconque des éléments 28 de génération de signal d'activation RST va maintenant être détaillé dans le cas N=3, fourni uniquement à titre d'exemple et pour une illustration simple, en référence à la figure 6.

Le démarrage de la génération du signal d'activation RST par l'élément 28 est initialement et indirectement déclenché par le passage de « 1 » à « 0 » du signal de référence RS généré par le bloc de sélection de ligne 22. A partir de cet instant et pendant une durée d'évaluation $T_e$ pendant laquelle le signal RST_Ref fourni par le bloc de référence 32 reste à « 1 » (ce qui maintient l'interrupteur 66 fermé), les signaux R et W passent à leur tour successivement à « 1 », pour que les interrupteurs 70 et 68 soient successivement fermés eux-mêmes et que le bloc d'évaluation 34 puisse tout d'abord lire la valeur courante de EXP dans la mémoire 60 avant de générer puis écrire dans la mémoire 60 une nouvelle valeur de EXP. Pendant tout ce temps, compte tenu du fonctionnement de la bascule RS 64, le signal RST prend la valeur « 1 ». En variante, il est possible d'anticiper la lecture de la valeur courante de EXP et de l'exécuter avant le passage à « 0 » du signal RS en adaptant le signal R.

A l'issue de cette évaluation, le signal RST_Ref prend la valeur « 0 », de sorte que c'est maintenant la comparaison de la valeur de EXP avec la valeur prise à chaque instant par le signal EXP_Ref qui devient déterminante pour fixer la valeur du signal RST. Cette valeur « 0 » est maintenue par RST-Ref pendant une durée de $2^3.T_{ligne}$ avant de repasser à « 1 ». Pour former avec RST_Ref une base de temps d'intégration de référence, le signal EXP-Ref est synchronisé avec RST_Ref de manière à porter la valeur « 0 » lors du passage à « 0 » de RST_Ref, maintenir cette valeur « 0 » pendant une durée de $2^2.T_{ligne}$ avant de passer à la valeur « 1 », maintenir cette valeur « 1 » pendant une durée de $2.T_{ligne}$ avant de passer à la valeur « 2 », maintenir cette valeur « 2 » pendant une durée de $T_{ligne}$ avant de passer à la valeur « 3 », puis maintenir cette valeur 3 au moins jusqu'à ce que le signal RST_Ref repasse à « 1 ».

De cette façon, dans cet exemple où N=3, si la valeur stockée en mémoire 60 de RST est « 0 », alors dès que RST_Ref passe à « 0 », EXP = EXP_Ref et la bascule RS 64 est configurée pour que RST passe à « 0 » et y reste tant que RST_Ref ne repasse pas à « 1 ». Ainsi on a bien $T_{int} = 2^3.T_{ligne} = 2^{3-EXP}.T_{ligne}$.

Si la valeur stockée en mémoire 60 de RST est « 1 », alors lorsque RST_Ref passe à « 0 », il faut attendre encore $2^2.T_{ligne}$ avant que EXP = EXP_Ref. Ainsi on a bien de nouveau $T_{int} = 2^3.T_{ligne} - 2^2.T_{ligne} = 2^2.T_{ligne} = 2^{3-EXP}.T_{ligne}$.

Si la valeur stockée en mémoire 60 de RST est « 2 », alors lorsque RST_Ref passe à « 0 », il faut attendre encore $2^2.T_{ligne} + 2.T_{ligne}$ avant que EXP = EXP_Ref. Ainsi on a bien de nouveau $T_{int} = 2^3.T_{ligne} - {}^2.T_{ligne} - 2.T_{ligne} = 2.T_{ligne} = 2^{3-EXP}.T_{ligne}$.

Enfin, si la valeur stockée en mémoire 60 de RST est « 3 », alors lorsque RST_Ref passe à « 0 », il faut attendre encore $2^2.T_{ligne} + 2.T_{ligne} + T_{ligne}$ avant que EXP = EXP_Ref. Ainsi on a bien de nouveau $T_{int} = 2^3.T_{ligne} - 2^2.T_{ligne} - 2.T_{ligne} - T_{ligne} = T_{ligne} = 2^{3-EXP}.T_{ligne}$.

Il apparaît donc clairement que l'architecture détaillée en référence à la figure 5 de l'élément 28 lui permet de générer un signal d'activation approprié et propre au pixel auquel il est associé à partir de la base de temps d'intégration fournie par le bloc de référence 32 (signal RST_Ref combiné à EXP_Ref) et du paramètre de temps d'intégration EXP. Selon le même principe, l'architecture de l'élément 28 sera aisément adaptée aux différentes variantes possibles d'implémentation, en fonction du mode de lecture des pixels, de la valeur de N et des différentes valeurs souhaitées pour EXP.

Le fonctionnement du bloc d'évaluation 34 va maintenant être décrit en référence à a figure 7. D'une façon générale, il est conçu pour adapter à chaque lecture la valeur du paramètre de temps d'intégration EXP de chaque élément 28 de génération de signal d'activation à la luminosité à laquelle est réellement soumis le pixel 18 correspondant. Par souci de clarté, ce fonctionnement sera détaillé pour le traitement d'un seul élément 28.

Ainsi, lors d'une étape 100, la valeur courante du paramètre EXP est lue dans la mémoire 60 de l'élément 28 via le bus 36C correspondant. Lors d'une étape 102, la valeur courante de la mantisse M du pixel 18 correspondant est transmise au bloc d'évaluation 34 par le convertisseur analogique numérique 24 du premier substrat par l'intermédiaire d'une connexion verticale. Ces valeurs courantes peuvent être issues de la dernière lecture séquentielle des valeurs de la matrice 20 de pixels 18 pour la mise à jour du paramètre EXP pour la prochaine lecture, ou d'une pré-lecture pour la lecture en cours : notamment, la pré-lecture peut consister en une première évaluation de la mantisse M au bout d'un temps minimal de lecture (par exemple la durée $T_{ligne}$), une décision sur l'ajustement du temps d'intégration étant prise pendant que l'intégration du pixel considéré continue. En variante également, les valeurs de mantisses de plusieurs pixels voisins peuvent être prises en compte.

Ensuite, lors d'une étape 104, un test est réalisé par le bloc d'évaluation 34 pour déterminer si la mantisse M est saturée, c'est-à-dire si tous ses bits sont à « 1 ». Si c'est le cas, on passe alors à une étape 106 lors de laquelle le bloc d'évaluation 34 affecte la valeur maximale N au paramètre EXP, puis à une étape 108 d'écriture de cette nouvelle valeur de EXP dans la mémoire 60 via le bus 36C.

Si la mantisse M n'est pas saturée, l'étape 104 est suivie d'une étape 110 lors de laquelle le nombre Nz de bits de poids forts successifs à « 0 » de cette mantisse M est compté à partir du bit de poids le plus fort.

Lors d'une étape 112 optionnelle, un test est éventuellement réalisé par le bloc d'évaluation 34 pour déterminer si les bits de la mantisse autres que ces Nz bits de poids forts successifs à « 0 » sont tous à « 1 », c'est-à-dire si le reste de la mantisse est saturé. Si c'est le cas, on passe alors à une étape 114 lors de laquelle le bloc d'évaluation 34 soustrait la valeur Nz-1 au paramètre EXP, puis à l'étape 108 d'écriture de cette nouvelle valeur de EXP dans la mémoire 60. Sinon, on passe alors à une étape 116 lors de laquelle le bloc d'évaluation 34 soustrait la valeur Nz au paramètre EXP, puis à l'étape 108 d'écriture de cette nouvelle valeur de EXP dans la mémoire 60. Dans un mode de réalisation de l'invention, l'étape de test 112 n'est par exemple exécutée que pour Nz=1.

Pour illustrer concrètement ce fonctionnement à l'aide d'un exemple, prenons M = 0001101010 une mantisse codée sur 10 bits et EXP = 4 la valeur courante du paramètre de temps d'intégration pour N = 10, correspondant à un temps d'intégration de $2^{10-4}.T_{ligne}$. Lors de l'étape 104, il est établi que cette mantisse M n'est pas saturée. Ensuite, lors de l'étape 110, Nz est estimé à 3, puisque les trois premiers bits de poids forts de la mantisse M sont à « 0 » alors que le quatrième est à « 1 ». Lors de l'étape 112, il est établi que le reste de la mantisse M n'est pas saturé. Ainsi, lors de l'étape 116, le paramètre EXP est mis à jour à la valeur 4-3 = 1.

La figure 8 représente schématiquement une implémentation possible du bloc d'évaluation 34, conformément au mode de réalisation de l'invention dans lequel le dispositif imageur 10 présente autant d'éléments 28 que de pixels 18, dans lequel les pixels 18 sont conformes au pixel 3T de la figure 2, dans lequel le mode de lecture de la matrice 20 est le « rolling shutter » et dans lequel l'étape de test 112 n'est exécutée que lorsque Nz=1. Mais comme précédemment, cette implémentation peut être aisément adaptée à tout type de pixels, à tout type de mode de lecture et à des imageurs dont chaque élément 28 de génération de signal d'activation adresse son signal d'activation de charge et de décharge à plusieurs pixels 18.

Selon cette implémentation, le bloc d'évaluation 34 comporte un module 80 de transcodage de mantisse, recevant une valeur de mantisse M (de 10 bits dans l'exemple de la figure 8) et fournissant, grâce à une combinaison de fonctions logiques ET (« AND » sur la figure 8) et NON-OU (« NOR » sur la figure 8), un mot binaire de même taille, B = [b10, b9, ..., b1], dont les Nz bits de poids forts sont à « 1 » et les autres à « 0 » (ou le contraire dans le cas où l'on utilise des portes OU à la place des portes NON-OU). En outre, deux fonctions logiques ET en cascade fournissent un paramètre sat prenant la valeur « 1 » lorsque la mantisse M est saturée.

Le mot binaire B fourni est mémorisé dans un registre à décalage 82 recevant en outre en entrée un signal d'horloge CK, conçu pour générer au moins 10 coups d'horloge pendant la durée d'évaluation $T_e$. En sortie de ce registre à décalage 82, une porte logique ET (« AND » sur la figure 8) réalise une fonction logique ET entre la sortie du registre et le signal d'horloge CK. Ainsi, tout bit à « 1 » de B correspond à un coup d'horloge fourni en entrée d'un décompteur 84 dans lequel est mémorisé le paramètre EXP courant, ce qui revient à soustraire une unité de la valeur du paramètre EXP à chaque fois. Au final, l'opération EXP-Nz est bien réalisée dans le décompteur 84.

Enfin, en sortie du décompteur 84, un interrupteur commandé par le paramètre sat fournit au bus 36C, pour la mise à jour de EXP dans la mémoire 60, soit N si sat=1, soit la nouvelle valeur de EXP mémorisée dans le décompteur 84 si sat=0.

Il apparaît clairement qu'un dispositif imageur à grande gamme dynamique tel que celui décrit précédemment permet de profiter des nouvelles possibilités offertes par la conception de puces en substrats superposés, dites puces 3D, pour déporter la commande de l'adaptation du temps d'intégration de chaque pixel ou groupe de pixels sur un substrat autre que celui sur lequel sont disposés les pixels et leurs circuits de lecture associés. Ainsi, à partir d'une architecture 2D classique d'imageur à un seul substrat, il devient simple de concevoir un dispositif imageur 3D à grande gamme dynamique sans nuire aux performances, notamment en faible luminosité, de l'architecture 2D initiale.

Par ailleurs, le codage sous forme de mantisse et d'exposant de la valeur de chaque pixel garantit non seulement la linéarité de la réponse du pixel mais aussi une meilleure compression des données puisqu'il constitue lui-même une première étape de compression.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

Entre autre, il a été indiqué que chaque élément 28 de génération de signal d'activation peut être associé à un groupe de pixel, notamment un bloc ou macro-bloc de pixels, chaque bloc ou macro-bloc recevant ainsi son propre signal RST. Ceci permet de mettre en oeuvre l'invention tout en relâchant les contraintes sur les connexions verticales 38 et d'avoir des tailles de pixels plus réduites. En effet, alors que si l'on prévoit un élément 28 de génération de signal d'activation par pixel 18, il est nécessaire de prévoir un encombrement d'au moins 5 $\mu$m par pixel, cet encombrement peut descendre jusqu'à 1,5-2 $\mu$m par pixel par exemple si l'on choisit de prévoir 8 éléments 28 pour des groupes de 8x8 pixels.

Dans ce cas, après évaluation par le bloc d'évaluation 34 de tous les paramètres de temps d'intégration des pixels de chaque bloc, un paramètre unique par bloc est choisi. Avantageusement, il s'agit du maximum des paramètres EXP de ce bloc, correspondant au minimum des temps d'intégration. C'est ce choix qui donne les meilleures performances parce qu'il permet de ne saturer aucun des pixels du bloc. Mais un inconvénient de l'application d'un signal d'activation par bloc est, lorsque les blocs sont trop gros, de faire apparaître des effets de blocs. Il convient alors de choisir une taille de bloc ou maro-bloc suffisamment réduite pour que ces effets ne soient pas visibles.

Dans les revendications qui suivent, les termes utilisés ne doivent pas être interprétés comme limitant les revendications aux modes de réalisation exposés dans la présente description, mais doivent être interprétés pour y inclure tous les équivalents que les revendications visent à couvrir du fait de leur formulation et dont la prévision est à la portée de l'homme de l'art en appliquant ses connaissances générales à la mise en oeuvre de l'enseignement qui vient de lui être divulgué.

Des domaines d'applications particulièrement adaptés à un dispositif imageur selon l'invention sont par exemple le secteur automobile et la vidéosurveillance. Mais tout autre domaine susceptible d'exploiter la propriété de grande gamme dynamique d'un imageur est également concerné.

## Revendications

**1.** Dispositif imageur (10) à grande gamme dynamique comportant sur un premier substrat (12) destiné à être exposé à la lumière :

- une pluralité de pixels (18), chaque pixel comportant un photodétecteur (40), et
- une pluralité de circuits de lecture (42) associés à la pluralité de photodétecteurs (40), chaque circuit de lecture (42) comportant un dispositif (46 ; 54 ; 56) de charge et de décharge d'au moins un photodétecteur associé à ce circuit de lecture, chaque dispositif de charge et de décharge étant commandé par un signal (RST ; TG) d'activation de la charge et de la décharge imposant un temps d'intégration du photodétecteur de chaque pixel associé au circuit de lecture,

le dispositif imageur comportant en outre un second substrat (14), distinct du premier substrat (12), sur lequel est disposé un circuit électronique (30, 32, 34) de commande desdits dispositifs de charge et de décharge (46 ; 54 ; 56), conçu pour la génération d'une pluralité de signaux (RST ; TG) d'activation de charge et de décharge destinés à être transmis auxdits dispositifs de charge et de décharge par l'intermédiaire de liaisons électriques (16) entre les premier (12) et second (14) substrats, chaque pixel ou groupe de pixels étant associé à un signal d'activation imposant un temps d'intégration propre et approprié à ce pixel ou groupe de pixels.

**2.** Dispositif imageur (10) selon la revendication 1, dans lequel les premier (12) et second (14) substrats sont superposés, lesdites liaisons électriques (16) comportant au moins l'un des éléments de l'ensemble constitué d'un via traversant réalisé à travers le premier et/ou le second substrat, d'une bille électriquement conductrice reliant électriquement un contact électrique du premier substrat à un contact électrique du second substrat, d'un contact électrique du premier substrat collé par adhésion moléculaire à un contact électrique du second substrat et de couplages capacitifs entre des contacts électriques respectifs des premier et second substrats.

**3.** Dispositif imageur (10) selon la revendication 1 ou 2, dans lequel le circuit électronique de commande (30, 32, 34) comporte :

- une pluralité d'éléments (28) de génération de signal d'activation (RST), chacun associé à un pixel ou groupe de pixels, et
- un bloc (34) d'évaluation de temps d'intégration destinés à être appliqués à la pluralité de pixels (18), conçu pour calculer et transmettre un paramètre de temps d'intégration (EXP) définissant un temps d'intégration propre et approprié à chaque élément (28) de génération de signal d'activation.

**4.** Dispositif imageur (10) selon la revendication 3, comportant un bloc de référence (32) conçu pour la fourniture d'une base de temps d'intégration de référence (EXP_Ref, RST_Ref) et dans lequel chaque élément (28) de génération de signal d'activation (RST) comporte un circuit (62, 64) de génération d'un signal d'activation (RST) à partir de la base de temps d'intégration (EXP_Ref, RST_Ref) fournie par le bloc de référence (32) et du paramètre de temps d'intégration (EXP) fourni par le bloc d'évaluation (34).

**5.** Dispositif imageur (10) selon la revendication 3 ou 4, dans lequel chaque paramètre de temps d'intégration (EXP), noté EXP, reçu par chaque élément (28) de génération de signal d'activation définit un temps d'intégration $T_{int}$ appliqué par le signal d'activation (RST) généré par cet élément (28), selon la relation suivante :

$$T_{\text{int}} = T_{ligne} \cdot 2^{N-EXP}, \quad où \quad EXP \in \{0,\ldots,N\}, \; T_{ligne}$$

étant un temps minimal d'intégration et N une valeur entière maximale prise par le paramètre de temps d'intégration.

**6.** Dispositif imageur (10) selon l'une quelconque des revendications 3 à 5, dans lequel le bloc (34) d'évaluation de temps d'intégration est conçu pour, sur la base d'une valeur courante de chaque paramètre de temps d'intégration (EXP) et d'une valeur courante de luminance de chaque pixel (18) mesurée par chaque circuit de lecture (42), calculer une nouvelle valeur de chaque paramètre de temps d'intégration (EXP).

**7.** Dispositif imageur (10) selon l'une quelconque des revendications 3 à 6, dans lequel le circuit électronique de commande (30, 32, 34) comporte un élément (28) de génération de signal d'activation par pixel (18).

**8.** Dispositif imageur (10) selon l'une quelconque des revendications 3 à 6, dans lequel les pixels (18) étant répartis en groupes de pixels, notamment en blocs ou macro-blocs de pixels, le circuit électronique de commande (30, 32, 34) comporte un élément (28) de génération de signal d'activation par groupe de pixels.

**9.** Dispositif imageur (10) selon l'une quelconque des revendications 3 à 8, dans lequel les pixels (18) sont disposés en matrice (20) sur le premier substrat (12) et le circuit électronique de commande (30, 32, 34) comporte une pluralité d'éléments (28) de génération de signal d'activation disposés en matrice (30) sur le second substrat (14), chaque élément (28) de génération de signal d'activation étant relié à un pixel (18) ou groupe de pixels par l'intermédiaire d'une liaison électrique (38) entre les premier et second substrat.

**10.** Dispositif imageur (10) selon l'une quelconque des revendications 1 à 9, dans lequel :

- chaque circuit de lecture (42) comporte trois transistors, un transistor de réinitialisation (46), un transistor suiveur (48) et un transistor de sélection de ligne (44), et
- le dispositif de charge et de décharge (46 ; 54 ; 56) comporte le transistor de réinitialisation (46).

**11.** Dispositif imageur (10) selon l'une quelconque des revendications 1 à 9, dans lequel :

- chaque circuit de lecture (42) comporte quatre transistors, un transistor de réinitialisation (46), un transistor de transfert (56), un transistor suiveur (48) et un transistor de sélection de ligne (44), et
- le dispositif de charge et de décharge (46 ; 54 ; 56) comporte le transistor de transfert (56).

**Patentansprüche**

1. Abbildungsvorrichtung (10) mit großem dynamischen Umfang, die auf einem ersten Substrat (12), das dazu bestimmt ist, dem Licht ausgesetzt zu werden, Folgendes umfasst:

   - eine Vielzahl an Pixeln (18), wobei jedes Pixel einen Fotodetektor (40) umfasst, und
   - eine Vielzahl an Leseschaltungen (42), die der Vielzahl an Fotodetektoren (40) zugeordnet sind, wobei jede Leseschaltung (42) eine Vorrichtung (46; 54; 56) zum Laden und Entladen von mindestens einem dieser Leseschaltung zugeordneten Fotodetektor umfasst, wobei jede Lade- und Entlade-Vorrichtung durch ein Signal (RST; TG) zur Aktivierung des Ladevorgangs und des Entladevorgangs gesteuert wird, das eine Integrationszeit des der Leseschaltung zugeordneten Fotodetektors eines jeden Pixels vorgibt,

   wobei die Abbildungsvorrichtung weiter umfasst ein vom ersten Substrat (12) separates zweites Substrat (14), auf dem eine elektronische Schaltung (30, 32, 34) zur Steuerung der genannten Lade- und Entlade-Vorrichtungen (46; 54; 56) angeordnet ist, und das so beschaffen ist, dass es eine Vielzahl an Signalen (RST; TG) zur Aktivierung des Ladevorgangs und des Entladevorgangs generiert und die dazu bestimmt sind, an die genannten Lade- und Entlade-Vorrichtungen mittels elektrischer Verbindungen (16) zwischen dem ersten (12) und dem zweiten Substrat (14) übertragen zu werden, wobei jedes Pixel oder jede Pixelgruppe einem Aktivierungssignal zugeordnet ist, das diesem Pixel oder dieser Pixelgruppe eine eigene und geeignete Integrationszeit vorgibt.

2. Abbildungsvorrichtung (10) nach Anspruch 1, bei dem die ersten (12) und zweiten Substrate (14) übereinander angeordnet sind, wobei die genannten elektrischen Verbindungen (16) mindestens eines der Elemente aus der Gruppe umfassen, die aus einer Durchkontaktierung, die durch das erste und/oder das zweite Substrat realisiert wird, aus einer elektrisch leitenden Kugel, die einen elektrischen Kontakt des ersten Substrats mit einem elektrischen Kontakt des zweiten Substrats elektrisch verbindet, aus einem elektrischen Kontakt des ersten Substrats, der durch molekulare Haftung an einen elektrischen Kontakt des zweiten Substrats geklebt wird, und aus kapazitiven Kopplungen zwischen den entsprechenden elektrischen Kontakten des ersten und zweiten Substrats besteht.

3. Abbildungsvorrichtung (10) nach Anspruch 1 oder 2, bei dem die elektronische Steuerschaltung (30, 32, 34) Folgendes umfasst:

   - eine Vielzahl an Elementen (28) zur Erzeugung eines Aktivierungssignals (RST), die einem Pixel oder einer Pixelgruppe jeweils zugeordnet sind, und
   - ein Block (34) zur Auswertung der Integrationszeiten, die dazu bestimmt sind, auf die Vielzahl an Pixeln (18) angewendet zu werden, der dazu beschaffen ist, einen Parameter der Integrationszeit (EXP) zu berechnen und zu übertragen, wobei dieser Parameter eine eigene und geeignete Integrationszeit für jedes Element (28) zur Erzeugung eines Aktivierungssignals definiert.

4. Abbildungsvorrichtung (10) nach Anspruch 3, die einen Referenzblock (32) umfasst, der zur Bereitstellung einer Referenz-Integrationszeit-Basis (EXP_Ref, RST_Ref) beschaffen ist, und in dem jedes Element (28) zur Erzeugung eines Aktivierungssignals (RST) eine Schaltung (62, 64) zur Erzeugung eines Aktivierungssignals (RST) umfasst, ausgehend von der Referenz-Integrationszeit-Basis (EXP_Ref, RST_Ref), die vom Referenzblock (32) bereitgestellt wird, und ausgehend vom Parameter der Integrationszeit (EXP), der vom Auswertungsblock (34) bereitgestellt wird.

5. Abbildungsvorrichtung (10) nach Anspruch 3 oder 4, bei dem jeder als EXP gekennzeichneter Parameter der Integrationszeit (EXP), der durch das Element (28) zur Erzeugung eines Aktivierungssignals empfangen wird, eine Integrationszeit $T_{int}$ definiert, die durch das Aktivierungssignal (RST) angewendet wird, das durch dieses Element (28) erzeugt wird, die der folgenden Beziehung genügt:

$$T_{int} = T_{ligne} \cdot 2^{N-EXP} \quad \text{wobei} \quad EXP \in \{0,...,N\},$$

   wobei $T_{ligne}$ einen minimalen Integrationszeitraum und N einen ganzzahligen maximalen Wert bezeichnet, der vom Integrationszeitparameter genommen wird.

6. Abbildungsvorrichtung (10) nach irgendeinem der Ansprüche von 3 bis 5, bei dem der Block (34) zur Auswertung der Integrationszeit dazu beschaffen ist, auf der Grundlage eines aktuellen Wertes eines jeden Integrationszeitparameters (EXP) und eines aktuellen Wertes der Helligkeit eines jeden Pixels (18), die durch jede Leseschaltung (42) gemessen wird, einen neuen Wert für jeden Integrationszeitparameter (EXP) zu berechnen.

7. Abbildungsvorrichtung (10) nach irgendeinem der Ansprüche von 3 bis 6, bei dem die elektronische Steuerschaltung (30, 32, 34) ein Element (28) zur Erzeugung eines Aktivierungssignals pro Pixel (18) umfasst.

8. Abbildungsvorrichtung (10) nach irgendeinem der Ansprüche von 3 bis 6, bei dem die elektronische Steuerschaltung (30, 32, 34) ein Element (28) zur Erzeugung eines Aktivierungssignals pro Pixelgruppe umfasst, wobei die Pixel (18) in Pixelgruppen unterteilt sind, insbesondere in Pixel-Blöcke oder -Makroblöcke.

9. Abbildungsvorrichtung (10) nach irgendeinem der Ansprüche von 3 bis 8, bei dem die Pixel (18) in einer Matrix (20) auf dem ersten Substrat (12) angeordnet sind, und die elektronische Steuerschaltung (30, 32, 34) eine Vielzahl an Elementen (28) zur Erzeugung eines Aktivierungssignals umfasst, die in einer Matrix (30) auf dem zweiten Substrat (14) angeordnet sind, wobei jedes Element (28) zur Erzeugung eines Aktivierungssignals mit einem Pixel (18) oder mit einer Pixelgruppe über eine elektrische Verbindung (38) zwischen dem ersten und dem zweiten Substrat verbunden ist.

10. Abbildungsvorrichtung (10) nach irgendeinem der Ansprüche von 1 bis 9, bei dem:

   - jede Leseschaltung (42) drei Transistoren umfasst, einen Rücksetz-Transistor (46), einen Folger-Transistor (48) und einen Leitungsauswahl-Transistor (44), und
   - die Lade- und Entlade-Vorrichtung (46; 54; 56) den Rücksetz-Transistor (46) umfasst.

11. Abbildungsvorrichtung (10) nach irgendeinem der Ansprüche von 1 bis 9, bei dem:

   - jede Leseschaltung (42) vier Transistoren umfasst, einen Rücksetz-Transistor (46), einen Übertragungs-Transistor (56), einen Folger-Transistor (48) und einen Leitungsauswahl-Transistor (44), und
   - die Lade- und Entlade-Vorrichtung (46; 54; 56) den Übertragungs-Transistor (56) umfasst.

## Claims

1. A high dynamic range imaging device (10) comprising on a first substrate (12) to be exposed to light:

   - multiple pixels (18), each pixel comprising a photodetector (40), and
   - multiple read-out circuits (42) associated with the multiple photodetectors (40), each read-out circuit (42) comprising a device (46, 54, 56) for charging and discharging at least one photodetector that is associated with this read-out circuit, each charging and discharging device being controlled by a charge and discharge activation signal (RST, TG) imposing an integration time of the photodetector of each pixel associated with the readout circuit,

   wherein the imaging device furtherr comprises a second substrate (14), distinct from the first substrate (12), on which there is an electronic control circuit (30, 32, 34) for controlling said charging and discharging devices (46, 54, 56), designed for generating multiple charge and discharge activation signals (RST, TG) to be transmitted to said charging and discharging devices by means of electrical connections (16) between the first (12) and second (14) substrates, each pixel or group of pixels being associated to an activation signal imposing an integration time that is specific and appropriate to this pixel or group of pixels.

2. An imaging device (10) according to claim 1, wherein the first (12) and second (14) substrates are stacked, said electrical connections (16) comprising at least one of the elements of the set consisting of a through via achieved through the first and/or the second substrate, an electrically conductive ball electrically connecting an electrical contact from the first substrate to an electrical contact of the second substrate, an electrical contact of the first substrate bonded by molecular adhesion to an electrical contact of the second substrate and capacitive couplings between the respective electrical contacts of the first and second substrates.

3. An imaging device (10) according to claim 1 or 2, wherein the electronic control circuit (30, 32, 34) comprises:

   - multiple elements (28) generating an activation signal (RST), each associated to a pixel or group of pixels, and

- a block (34) evaluating the integration time to be applied to the multiple pixels (18), designed to calculate and transmit an integration time parameter (EXP), defining an integration time which is specific and appropriate to each element (28) generating an activation signal.

4. An imaging device (10) according to claim 3, comprising a reference block (32) designed to provide a base of reference integration times (EXP_Ref, RST_Ref) and in which each element (28) generating an activation signal (RST) comprises a circuit (62, 64) for generating an activation signal (RST) from the base of integration times (EXP_Ref, RST_Ref) supplied by the reference block (32) and from the integration time parameter (EXP) supplied by the evaluation block (34).

5. An imaging device (10) according to claim 3 or 4, wherein each integration time parameter (EXP), noted EXP, received by each element (28) generating an activation signal defines an integration time $T_{int}$ applied by the activation signal (RST) generated by this element (28), according to the following relation:

$$T_{\mathrm{int}} = T_{line} \cdot 2^{N-EXP}, \quad where \quad EXP \in \{0, \ldots, N\},$$

$T_{line}$ being a minimum integration time and N being a maximum integer value taken by the integration time parameter.

6. An imaging device (10) according to any one of claims 3 to 5, wherein the block (34) evaluating the integration time is designed for calculating a new value for each integration time parameter (EXP) based on a current value of each integration time parameter (EXP) and of a current value of luminance for each pixel (18) measured by each read-out circuit (42).

7. An imaging device (10) according to any one of claims 3 to 6, wherein the electronic control circuit (30, 32, 34) comprises an element (28) generating an activation signal (18) per pixel.

8. An imaging device (10) according to any one of claims 3 to 6, wherein, because the pixels (18) are arranged into groups of pixels, such as blocks or macroblocks of pixels, the electronic control circuit (30, 32, 34) comprises one element (28) generating an activation signal per group of pixels.

9. An imaging device (10) according to any one of claims 3 to 8, wherein the pixels (18) are arranged in an array (20) on the first substrate (12), and the electronic control circuit (30, 32, 34) comprises multiple elements (28) generating an activation signal, arranged in an array (30) on the second substrate (14), each element (28) generating an activation signal being connected to a pixel (18) or group of pixels by means of an electrical connection (38) between the first and second substrate.

10. An imaging device (10) according to any one of claims 1 to 9, wherein:

   - each read-out circuit (42) comprises three transistors: a reset transistor (46), a follower transistor (48), and a line selection transistor (44), and
   - the charging and discharging device (46, 54, 56) comprises the reset transistor (46).

11. An imaging device (10) according to any one of claims 1 to 9, wherein:

   - each read-out circuit (42) comprises four transistors: a reset transistor (46), a transfer transistor (56), a follower transistor (48), and a line selection transistor (44), and
   - the charging and discharging device (46, 54, 56) comprises the transfer transistor (56).

## Figure 1

## Figure 2

## Figure 3

## Figure 4

## Figure 5

## Figure 6

**Figure 7**

```
┌────────┐              ┌────────┐
│  100   │              │  102   │
└───┬────┘              └───┬────┘
    │                       │
    │                       ▼
    │                    ╱──────╲
    │                   ◇  104   ◇─────────────┐
    │                    ╲──────╱               │
    │                       │                   │
    │                       ▼                   ▼
    │                   ┌────────┐          ┌────────┐
    │                   │  110   │          │  106   │
    │                   └───┬────┘          └───┬────┘
    │                       │                   │
    │                       ▼                   │
    │                    ╱──────╲               │
    │                   ◇  112   ◇──────┐       │
    │                    ╲──────╱       │       │
    │                       │           │       │
    │                       ▼           │       │
    │   ┌─────────────►┌────────┐       │       │
    │   │              │  116   │       │       │
    │   │              └───┬────┘       │       │
    │   │                  │            │       │
    └───┘                  │      ┌─────┘       │
                           │      ▼             │
                           └───►┌────────┐◄─────┘
                                │  114   │
                                └───┬────┘
                                    │
                                    ▼
                                ┌────────┐
                                │  108   │
                                └────────┘
```

**Figure 8**

*34*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080083939 A

**Littérature non-brevet citée dans la description**

- **EL GAMAL.** High dynamic range image sensors. *International Solid-State Circuits Conference,* 2002
- **YANG et al.** High dynamic range CMOS image sensor with conditional reset. *Custom Integrated Circuits Conference,* 2002

- **ACOSTA-SERAFINI et al.** A 1/3'' VGA linear wide dynamic range CMOS image sensor implementing a predictive multiple sampling algorithm with overlapping integration intervals. *IEEE Journal of Solid-State Circuits,* Septembre 2004, vol. 39 (9